# FASCICULE DE BREVET EUROPEEN

(11) **EP 0 589 030 B1**
(45) Date de publication et mention de la délivrance du brevet: **27.09.1995**
(21) Numéro de dépôt: 93909006.4
(22) Date de dépôt: 08.04.1993
(51) Int. Cl.: H01J 1/30, H01S 3/0959

(54) **CANON A ELECTRONS COMPACT COMPORTANT UNE SOURCE D'ELECTRONS A MICROPOINTES ET LASER A SEMI-CONDUCTEUR UTILISANT CE CANON POUR LE POMPAGE ELECTRONIQUE**
KOMPAKTE ELEKTRONENKANONE MIT EINER MIKROSPITZEN-ELEKTRONENQUELLE UND MIT EINER DERARTIGEN ELEKTRONENKANONE GEPUMPTER HALBLEITERLASER
COMPACT ELECTRON GUN COMPRISING A MICRO-POINT ELECTRON SOURCE, AND SEMICONDUCTOR LASER USING SAID GUN FOR ELECTRON PUMPING

(30) Priorité: 10.04.1992 FR 9204430
(43) Date de publication de la demande: 30.03.1994
(73) Titulaire: COMMISSARIAT A L'ENERGIE ATOMIQUE, 75752 Paris Cédex 15 (FR)
(72) Inventeur: MOLVA, Engin, F-38000 Grenoble (FR); ACCOMO, Roger, F-38420 Le Versoud (FR)
(74) Mandataire: Dubois-Chabert, Guy
(86) Numéro de dépôt international: FR9300353
(87) Numéro de publication internationale: WO9321646

(56) Documents cités:
- EP-A- 0 119 646
- EP-A- 0 379 325
- EP-A- 0 454 566
- WO-A-90/11609
- US-A- 3 803 510

## Description

La présente invention a pour objet un canon à électrons compact comportant une source froide d'électrons à micropointes.

De façon générale, le canon à électrons de l'invention comporte une source froide d'électrons à micropointes, une optique électronique simplifiée par rapport à celles des canons à électrons connus ainsi qu'une anode à haute tension bombardée par les électrons issus de la source froide. L'ensemble source-optique-anode est compact et présente un volume de quelques cm³.

Ce canon à électrons peut être utilisé dans un laser à semi-conducteur comme moyen de pompage électronique.

Un laser à semi-conducteur et à micropointes, noté LSM, est constitué d'une structure semi-conductrice comme milieu actif et d'un canon à électrons compact à micropointes comme moyen de pompage. Cette structure peut consister en un matériau semi-conducteur massif, en des matériaux semi-conducteurs en couches minces ou en une hétérostructure.

L'utilisation du canon à électrons de l'invention permet d'améliorer les performances du laser à semi-conducteur et en particulier permet l'obtention d'un fonctionnement à faible courant électronique, l'amélioration du rendement laser, une limitation des problèmes thermiques, une augmentation de la durée de vie des moyens de pompage et une meilleure fiabilité générale du laser dans son ensemble.

Ces améliorations sont obtenues grâce à la modification et à l'optimisation du canon à électrons compact de l'invention.

Un laser à semi-conducteur du type LSM permet notamment l'émission d'une lumière laser visible de 0,4 à 0,6µm dont les applications sont nombreuses. En effet, un tel laser peut être utilisé pour l'enregistrement et la lecture optique d'informations, par exemple sur des disques compacts audio et vidéo, des CD-ROM (disques compacts-mémoires à lecture seule), des mémoires WORM (une écriture-plusieurs lectures), des mémoires effaçables (du type magnéto-optique ou à changement de phase) ou dans les imprimantes laser.

Il peut aussi être utilisé dans d'autres applications comme par exemple dans les lecteurs de code barre - l'instrumentation de laboratoire, la spectroscopie, l'instrumentation bio-médicale, les pointeurs, les spectacles, la visualisation par projection, la communication sous-marine, etc.

Le canon à électrons compact de l'invention peut en outre être utilisé dans d'autres domaines que celui des lasers et de façon générale dans tout dispositif où il est nécessaire d'avoir des électrons accélérés avec des hautes tensions (typiquement de 0 à 40 kV), focalisés et le tout étant assemblé de façon compacte (typiquement de quelques cm³). A titre d'exemple, on peut utiliser le canon à électrons de l'invention dans un générateur de rayons X.

Pour l'enregistrement et la lecture optique d'informations, le laser compact utilisant le canon à électrons de l'invention permet une augmentation de la densité d'enregistrement et une simplification de l'instrumentation optique. Dans les imprimantes laser, le laser compact utilisant le canon à électrons de l'invention permet une meilleure définition de l'image et une augmentation de la vitesse d'impression par rapport aux systèmes connus.

Un laser à semi-conducteur compact du type à pompage électronique utilisant un canon à électrons avec une source à micropointes est notamment décrit dans le document FR-A-2 661 566 déposé au nom du demandeur. Ce laser comporte une cavité laser équipée d'une hétérostructure à semi-conducteur qui est le milieu actif laser. Cette hétérostructure constitue une anode portée à haute tension qui est bombardée avec des électrons énergétiques fournis par un canon compact.

Les lasers du type à pompage électronique seront utilisés dans les cas où les matériaux semi-conducteurs choisis ne permettent pas la réalisation de diodes laser à injection et dans les cas où il n'existe pas de source de pompage optique compacte.

Les avantages d'un LSM par rapport aux diodes laser à injection résident notamment dans la séparation des fonctions et éléments de pompage et de la cavité laser.

Dans les diodes laser à injection (les seuls lasers compacts qui existent sur le marché), ces fonctions de base (pompage, cavité) sont réalisées sur le semi-conducteur par des dopages électriques appropriés de type P et N de différentes couches épitaxiées, et par des prises de contacts électriques (de type ohmique).

Les différentes opérations de fabrication de ces diodes nécessitent une parfaite maîtrise de la technologie d'élaboration des hétérostructures et ne sont actuellement maîtrisées que pour certains semi-conducteurs de la famille des composés III-V (de type GaAlAs). Ceci limite le domaine de longueurs d'onde accessibles à ces diodes laser entre 0,6 et 1,5µm.

Dans les lasers du type LSM, l'injection des porteurs (électrons et trous) qui se recombinent dans la zone active du semi-conducteur pour générer l'émission de la lumière, se fait, par définition, par une source extérieure (canon à électrons) au milieu actif semi-conducteur. Par conséquent, il n'est pas nécessaire de doper de type P ou N les différentes couches épitaxiées du laser. Il n'est pas nécessaire non plus de prendre des contacts électriques.

Ceci simplifie extrêmement la métallurgie du milieu actif semi-conducteur, où seules les caractéristiques de confinement électrique (pompage électronique, puits quantiques), de confinement optique (guidage de la lumière avec un mode centré sur la zone active) et de longueur d'onde seront considérées.

Cet avantage permet d'utiliser dans les LSM tous les semi-conducteurs à gap direct, et en particulier les alliages II-VI à base de Zn, Cd, Mn, Mg, Hg et de S, Se, Te où les technologies de dopage et de contact ne sont pas ou mal maltrisées. Ces technologies sont d'autant plus difficiles que le gap des matériaux est grand et que donc la longueur d'onde d'émission est courte. Les LSM dans leur conception font disparaître ces problèmes technologiques.

La possibilité d'utiliser tous les semi-conducteurs à gap direct pour les LSM, rend accessible le domaine des longueurs d'onde entre le bleu et l'infrarouge moyen. En particulier, les LSM émettant dans le bleu-vert permettent de satisfaire aux besoins actuels pour toutes les applications concernant l'enregistrement optique. Ce domaine n'est pas actuellement couvert par les diodes laser à injection, qui sont les seuls lasers compacts commerciaux.

Des études sont actuellement en cours pour réaliser des diodes lasers émettant dans le bleu-vert, soit à partir des semi-conducteurs II-VI avec les difficultés citées ci-dessus, soit à partir de diodes laser III-V émettant dans l'infrarouge par doublage de fréquence ou par des effets non linéaires similaires.

Dans le laser de type LSM connu du document FR-A-2 661 566, la focalisation des électrons sur le milieu actif est essentiellement attribuée à la forme conique ou pyramidale de l'anode. Par ailleurs, des moyens de focalisation en ruban du faisceau d'électrons sont utilisés. Ces moyens sont constitués de deux écrans métalliques de forme trapézoïdale, disposés de chaque côté de la source à micropointes et proches de celle-ci.

La focalisation seulement par la forme spéciale de l'anode s'avère imparfaite car on ne peut pas contrôler les dimensions ni la forme du spot de focalisation.

L'utilisation des deux écrans métalliques ne permet de contrôler qu'une des dimensions du ruban de focalisation.

La focalisation imparfaite, bien qu'elle n'empêche pas le LSM de fonctionner, nécessite un courant de fonctionnement élevé pour atteindre la densité de courant de seuil laser, pouvant entraîner des problèmes thermiques et une trop forte sollicitation des micropointes, les rendant plus vulnérables à des claquages. D'autre part, la focalisation imparfaite entraîne la perte d'une partie du faisceau électronique de pompage en dehors de la zone utile. Ceci contribue à la baisse du rendement du laser.

Par ailleurs, les écrans qui sont de chaque côté de la source et proches de celle-ci ne l'écrantent pas par rapport à l'anode qui est portée à une haute tension. Les cathodes à micropointes subissent donc l'effet de la haute tension, c'est-à-dire que la source se trouve dans une zone de fort champ électrique. Ceci pourraît contribuer à un mauvais fonctionnement de la source, ou pourraît raccourcir la durée de vie de celle-ci.

Les problèmes cités ci-dessus contribuent à dégrader les performances et la fiabilité du LSM connu.

La présente invention a justement pour objet un nouveau canon à électrons compact équipé d'une source froide d'électrons à micropointes permettant de remédier à ces inconvénients. En particulier, ce canon à électrons permet d'améliorer les performances du laser.

Il permet notamment l'utilisation d'un courant plus faible, d'une puissance de pompage plus faible et d'une densité d'excitation plus forte, ainsi que de meilleurs rendement et fiabilité, la diminution des problèmes thermiques et le maintien de la source à micropointes dans une zone de champ faible électrostatique.

De façon plus précise, l'invention a pour objet un canon à électrons compact comportant une source froide d'électrons pourvue de conducteurs cathodiques supportant des micropointes émettrices d'électrons ; une anode haute tension distante des micropointes, faisant face aux micropointes ; des moyens pour appliquer une haute tension sur l'anode ; un ensemble d'électrodes pour focaliser sur l'anode sous forme d'un ruban le faisceau d'électrons émis par la source et pour servir d'écran électrostatique à la source contre la haute tension appliquée à l'anode, cet ensemble étant interposé entre la source et l'anode et comportant au moins deux paires d'électrodes de dimensions distinctes et portées respectivement à des tensions positives et négatives dont leur valeur est telle qu'un champ électrostatique faible est créé entre la source et l'ensemble d'électrodes et qu'un champ électrostatique fort est créé entre l'ensemble d'électrodes et l'anode, ces électrodes étant réparties autour du faisceau d'électrons, des moyens pour appliquer une tension moyenne sur l'ensemble d'électrodes, et des moyens pour appliquer une tension appropriée sur les conducteurs cathodiques.

Par "champ faible", il faut comprendre des champs électrostatiques au plus égaux à 1000V/cm et par "champ fort", il faut comprendre des champs électrostatiques au moins égaux à 2000V/cm.

La source froide d'électrons à micropointes permet de bombarder l'anode avec des électrons accélérés entre 0-40 kV.

En plus des conducteurs cathodiques, la source froide comporte des électrodes de grille isolées des conducteurs cathodiques. Les conducteurs cathodiques et les électrodes de grille sont constitués respectivement de bandes parallèles, les électrodes cathodiques étant perpendiculaires aux électrodes de grille.

Les électrodes de grilles sont équipées de trous en regard des micropointes.

La fonction de la source à micropointes est d'émettre des électrons avec une polarisation grilles-cathodes de 80-150 volts et la forme du réseau de micropointes a une importance sur la forme et les dimensions de la tache de focalisation sur la cible (ici anode). Ainsi, la forme du réseau de micropointes intervient dans la définition de l'optique électronique.

Pour une focalisation en ruban, il est préférable d'utiliser par exemple un réseau de micropointes rectangulaire.

La fonction de l'anode, portée à une haute tension par une source d'alimentation haute tension (0-40kV), est d'accélérer et de collecter les électrons émis par la source à micropointes et focalisés par l'ensemble des électrodes. L'anode qui sert de cible au faisceau électronique fait partie de l'optique électronique, car elle intervient aussi dans la détermination des lignes de champ électrique, et donc des trajectoires des électrons. En particulier, sa forme peut influer sur les équipotentielles et les lignes de champ.

Les fonctions de l'optique électronique sont les suivantes :
1°) - la focalisation des électrons en ruban et le contrôle des dimensions du ruban pour son adaptation à la cible (anode). Dans le cas d'un laser à semi-conducteur, la largeur du ruban doit être minimum et sa longueur doit être celle de la largeur de la cavité laser (distance entre les faces miroirs clivées de la cavité Fabry-Perot).
2°) - la séparation en deux zones de champ électrique : champ fort entre les électrodes et l'anode ou la cavité laser dans le cas particulier d'un LSM ; champ faible entre les électrodes et la source à micropointes. En effet, les électrodes ou écrans électrostatiques sont portés à des tensions moyennes de ± 50 à ± 800volts et se trouvent en outre placés entre la source et l'anode.

Cette séparation en deux zones de champ électrique : côté source à micropointes - champ faible (0,2-1kV/cm) ; côté anode - champ fort (2-10kV/cm) a pour effet de stabiliser le fonctionnement des micropointes, de prolonger leur durée de vie en évitant notamment les claquages électriques accidentels, et de simplifier la mise en forme et la focalisation du faisceau d'électrons.

De plus, l'agencement des électrodes permet une bonne prise en compte des problèmes thermiques. En effet, la puissance énergétique reçue par l'anode est égale au produit de la tension d'accélération et du courant électronique. Une partie importante (>50% dans le cas du LSM) de cette énergie est transformée en chaleur, et doit être évacuée pour le bon fonctionnement du dispositif. Cette énergie reçue par l'anode est minimisée grâce à la bonne focalisation qui diminue le courant électronique. La fraction excédentaire est évacuée efficacement vers l'extérieur par l'anode.

L'optique électronique (anode + électrodes) permet une focalisation en ruban de largeur typiquement de 5 à 150µm et de longueur de 100 à 2000µm.

Eventuellement et si nécessaire, l'ensemble d'électrodes permet un balayage du faisceau d'électrons.

Pour une mise en forme préliminaire du faisceau d'électrons, il est possible d'utiliser des électrodes multiples au niveau des grilles de la source à micropointes, des lentilles électromagnétiques ou encore de simples bobines de fil parcouru par un courant et entourant le faisceau d'électrons.

La focalisation en ruban des électrons, qui est adaptée à la forme de l'anode, en particulier de forme cônique ou pyramidale, permet :
- de diminuer le courant électronique pour une densité de courant électronique donnée. Ceci permet de moins solliciter la source à micropointes et donc d'améliorer sa tenue et sa durée de vie. Ceci permet également de diminuer la puissance déposée sur la cible, pour une même densité de courant et donc de chauffer moins la cible. Ceci est particulièrement important dans le cas d'un laser de type LSM.
- d'augmenter la densité de courant pour un courant donné. Ceci permet pour une même puissance d'excitation d'améliorer le rendement de conversion (par exemple dans le cas du laser le rapport puissance du laser/puissance d'excitation). Ceci permet aussi d'atteindre des densités d'excitation beaucoup plus élevées.
- d'augmenter le rendement du canon en perdant le moins possible d'électrons en dehors de la cible.

Le canon à électrons de l'invention décrit ci-dessus est parfaitement bien adapté pour le pompage électronique d'un laser semi-conducteur. Aussi, l'invention a encore pour objet un laser à semi-conducteur pompé électroniquement dans lequel les moyens de pompage sont constitués du canon à électrons de l'invention.

Le laser auquel s'applique l'invention peut utiliser comme milieu actif un matériau semi-conducteur massif, des matériaux semi-conducteurs en couches minces ou une hétérostructure semi-conductrice.

Les performances d'un laser à hétérostructure sont nettement supérieures à celle d'un laser à semi-conducteur en matériau massif ou en couches minces. Aussi, on utilise avantageusement un laser a hétérostructure.

D'autres caractéristiques et avantages de l'invention ressortiront mieux de la description qui va suivre, donnée à titre illustratif et non limitatif, en référence aux figures annexées :
- la figure 1 représente schématiquement, en perspective, le principe du canon à électrons conforme à l'invention,
- la figure 2 représente, en perspective écorchée, la source froide à micropointes du canon de la figure 1,
- la figure 3 est un schéma montrant les lignes équipotentielles dans le canon à électrons de l'invention,
- la figure 4 montre des profils de focalisation en ruban du faisceau d'électrons du canon selon l'invention,
- les figures 5a à 5c représentent une première variante de réalisation du canon à électrons conforme à l'invention : la figure 5a est une vue de face de l'ensemble source-électrodes, la figure 5b est une vue selon la coupe B-B de la figure 5a et la figure 5c est une vue selon la coupe C-C de la figure 5a,
- les figures 6a à 6c représentent une seconde variante de réalisation du canon à électrons de l'invention : la figure 6a est une vue de dessus de l'ensemble source-électrodes, la figure 6b est une vue selon la coupe B-B de la figure 6a et la figure 6c est une vue en coupe selon la direction C-C de la figure 6a,
- les figures 7a à 7c représentent schématiquement une troisième variante de réalisation du canon à électrons de l'invention : la figure 7a est une vue de dessus de l'ensemble source-électrodes, la figure 7b est une vue en coupe selon la direction B-B de la figure 7a, la figure 7c est une vue en coupe selon la direction C-C de la figure 7a,
- la figure 8 est, en coupe, une quatrième variante de réalisation du canon de l'invention, et
- les figures 9a et 9b représentent schématiquement un laser à semi-conducteur comportant un canon à électrons conforme à l'invention comme moyens de pompage.

Le canon à électrons 1 conforme à l'invention est un canon compact dont l'ensemble, à l'exception des sources d'alimentation électrique, est placé dans une enceinte à vide secondaire ou ultravide, symbolisée en 2, de quelques cm³. Cette enceinte est équipée d'un système de pompes à vide symbolisé en 4 assurant notamment un vide poussé inférieur ou égal à 1,3.10³Pa (8 torrs).

Au lieu d'utiliser une enceinte ultravide, on peut assembler les différents éléments du canon à électrons dans un boîtier étanche et compact.

L'enceinte 2 ou le boîtier étanche du canon à électrons doit être conçu de façon à "écranter" électriquement le canon à électrons par rapport à l'extérieur. Aussi, si le boîtier ou l'enceinte 2 est métallique, il peut être porté au potentiel de la masse. S'il est isolant, ses surfaces internes peuvent être métallisées et mises au potentiel de la masse.

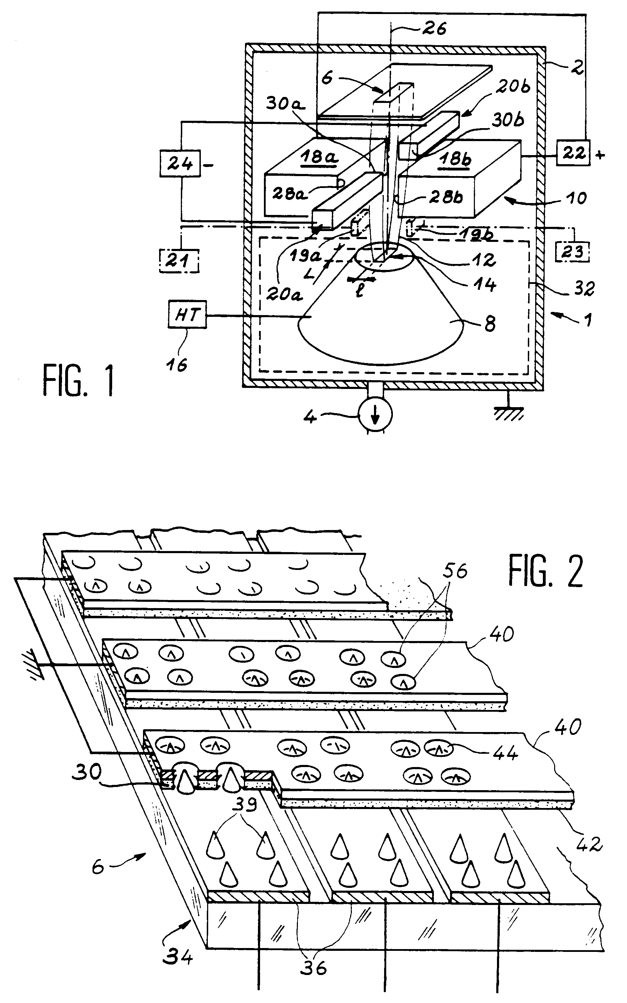

Dans l'enceinte ultravide 2, on trouve une source froide 6 d'électrons à micropointes, dont la structure sera décrite plus en détail en référence à la figure 2, et une anode haute tension 8, de forme pyramidale tronquée ou tronconique ; le sommet de l'anode est orienté vers la source et disposé parallèlement à la surface émettrice et à une certaine distance de cette dernière.

L'anode ou cible 8 est réalisée en métal massif, par exemple en cuivre, en molybdène. Sa hauteur est typiquement de 1 à 15mm. La distance source-anode est typiquement de 5 à 20mm.

Entre la source froide 6 et l'anode 8, on trouve un ensemble 10 d'électrodes destiné à focaliser sur la surface supérieure de l'anode le faisceau d'électrons 12 émis par la source froide 6.

Cet ensemble 10 d'électrodes est agencé pour former un ruban 14 à la surface supérieure de l'anode. Il sert en outre d'écran électrostatique à la source froide contre la haute tension appliquée à l'anode 8 grâce à une source d'alimentation électrique haute tension 16, extérieure à l'enceinte 2.

Selon l'invention, l'ensemble d'électrodes 10 comporte au moins deux paires d'électrodes de dimensions distinctes : une première paire d'électrodes 18a et 18b et une seconde paire d'électrodes 20a et 20b. Les électrodes 18a et 18b sont connectées à une même source d'alimentation électrique 22 délivrant une tension positive par rapport aux grilles de la source à électrons et les électrodes 20a et 20b sont connectées à une source d'alimentation électrique 24 délivrant une tension négative par rapport aux grilles de la source.

Afin de créer un champ électrostatique symétrique par rapport à l'axe de symétrie 26 du canon à électrons et donc du faisceau d'électrons 12, les électrodes 18a et 18b sont disposées symétriquement par rapport à cet axe 26. Il en est de même pour les électrodes 20a et 20b.

Les électrodes 18a et 18b, portées au potentiel positif par rapport aux grilles de la source, définissent et contrôlent la largeur l du ruban 14 alors que les électrodes 20a et 20b, portées au potentiel négatif par rapport à ces grilles, définissent et contrôlent sa longueur L.

Par ailleurs, les électrodes 18a comportent des faces respectivement 28a et 28b planes parallèles entre elles et faisant face au faisceau d'électrons 12.

De même, les électrodes 20a et 20b comportent des faces 30a et 30b parallèles entre elles et faisant face au faisceau 12. (Ces faces 30a et 30b sont donc perpendiculaires aux faces 28a et 28b).

Par ailleurs, la longueur des surfaces 28a et 28b est au moins égale à celle du ruban 14. De même, la longueur des faces 30a et 30b est au moins égale à la largeur l du ruban 14.

Dans le mode de réalisation représenté sur la figure 1, les électrodes présentent la forme de parallélépipèdes rectangles.

Ces électrodes peuvent être réalisées en métal ou en un isolant électrique métallisé. En outre, au lieu d'utiliser des surfaces rectangulaires en regard du faisceau d'électrons 14, on peut envisager d'autres formes qui peuvent être calculées par une simulation numérique. En général, cette forme est dérivée d'un rectangle.

L'ensemble 10 d'électrodes est bien entendu isolé électriquement de la source 6 et de l'anode 8 et par exemple sans contact avec la source et l'anode.

Cet ensemble 10, peut, si nécessaire, assurer un balayage électronique du faisceau 14.

Dans ce cas, on peut par exemple alimenter les électrodes 18a et 18b avec des tensions différentes afin de déplacer le faisceau sur la cible 8, dans le sens de la largeur l. On peut aussi envisager, comme représenté sur la figure 1, d'utiliser deux électrodes supplémentaires 19a, 19b juste en-dessous des électrodes 18a et 18b, côté cible, et portées à des potentiels différents grâce à des sources externes d'alimentation, respectivement 21 et 23.

Ces électrodes de déflexion 19a, 19b agiront sur la position du faisceau 12 sur la cible 8. Leur fonction serait la même que celle des plaques de déflexion dans un tube cathodique (télévision, oscilloscope).

La distance séparant les électrodes 18a et 18b est typiquement de 2 à 10mm et la distance séparant les électrodes 20a et 20b est typiquement de 5 à 10mm. La hauteur de ces électrodes, mesurée selon l'axe 26, est typiquement de 2 à 10mm. La distance séparant ces électrodes de la source 6 est typiquement de 0 à 10mm.

Le canon à électrons de la figure 1 comporte, par ailleurs, un système 32 du type radiateur ou refroidisseur (élément Peltier ou cryostat basse température) pour le contrôle de la température de la cible 8 bombardée par le faisceau électronique 12.

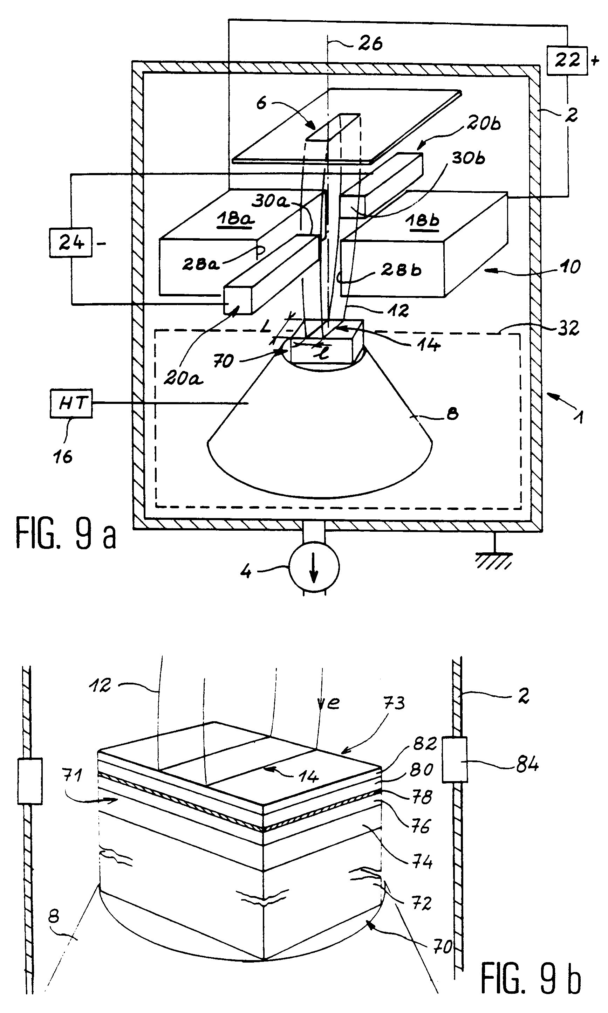

La conception du canon à électrons de l'invention doit être telle qu'il assure la focalisation en ruban du faisceau 12 selon une longueur L de 100 à 1000µm et une largeur l de 5 à 150µm. Dans le cas particulier d'un laser avec confinement latéral des modes (voir figures 9a et 9b), la longueur L du ruban doit être du même ordre de grandeur que celle de la cavité laser.

La source à micropointes 6 du canon de la figure 1 est représentée de façon plus détaillée sur la figure 2. Elle est fabriquée selon des techniques connues de la microélectronique notamment selon des procédés décrits dans les documents FR-A-2 593 953 et FR-A-2 663 452.

Elle comporte un substrat 34 isolant, généralement en verre supportant des conducteurs cathodiques 36 ayant la forme de bandes parallèles entre elles et à une direction x. Ces conducteurs cathodiques sont reliés électriquement à une source d'alimentation électrique 38 négative par rapport à la masse, placée à l'extérieur de l'enceinte 2 (figure 1).

Les cathodes 36 ont en particulier une largeur de 2 à 1000µm et sont séparées de 2 à 1000µm.

Ces cathodes 36 supportent des micropointes 39 réalisées en un matériau (molybdène par exemple) susceptible d'émettre des électrons. Elles ont en particulier un diamètre de base d'environ 1,5µm et sont espacées de 3 à 10µm, ce qui correspond de 10000 à 100000 micropointes par mm².

Avantageusement, les micropointes définissent une matrice de forme rectangulaire dont la longueur est typiquement de 0,5 à 1,5mm et la largeur typiquement de 5 à 500µm.

La source 6 comporte en outre des électrodes de grilles 40 ayant la forme de bandes conductrices perpendiculaires à la direction x. Ces grilles 40 reposent sur des bandes d'isolant électrique 42 assurant leur isolation électrique par rapport aux cathodes 36. Les grilles 40 sont portées en général au potentiel de la masse.

Les bandes isolantes 42 et les électrodes de grilles sont empilées en coïncidence. Elles présentent une largeur par exemple de 2 à 1000µm et sont espacées par exemple de 2 à 1000µm Les bandes isolantes 42 ainsi que les grilles 40 sont équipées de trous 44 débouchants dans lesquels font saillie les micropointes 39.

Les cathodes 36 et les grilles 40 sont réalisées en métal conducteur et par exemple en chrome, niobium,... tungstène, molybdène etc. L'isolant électrique 42 est en particulier de l'oxyde de silicium.

Si nécessaire, il est possible de modifier la forme des grilles 40 de façon qu'elles définissent des électrodes de grilles multiples pour chaque zone élémentaire d'émission.

On donne ci-après un exemple de fonctionnement du canon à électrons de l'invention.

L'anode 8 est portée à une tension positive continue ou pulsée typiquement de 0-40kV (0-10kV dans le cas d'un laser LSM).

Une différence de potentiel de 80-150V est créée entre les grilles 40 et les micropointes 39. Par exemple les grilles sont mises à la masse et les micropointes sont à un potentiel négatif. Pour un fonctionnement modulé ou pulsé, ce potentiel peut être modulé ou pulsé avec une fréquence de coupure typique d'environ 1MHz.

Cette différence de potentiel entre grilles et micropointes crée un champ électrique élevé d'environ 10⁺⁷V/cm au niveau des micropointes. Ce champ provoque l'émission froide des électrons. Le courant électronique typique peut aller jusqu'à 1 microampère par micropointe. Pour une source de 0,5mm sur 1mm de surface émettrice comportant environ 7000 micropointes, on obtient typiquement un courant de 100 microampères pour une tension grilles-cathodes de 80 volts.

Les électrons émis sont accélérés par la haute tension de l'anode 8 et passent à travers l'ensemble électronique 10 pour être focalisés sous forme du ruban 14 sur l'anode ou sur la cavité laser (figure 9).

Dans un exemple précis de réalisation, les valeurs typiques des tensions des écrans électrostatiques sont : +300 à +600 volts pour les électrodes 18a, 18b et -50 à -300 volts pour les électrodes 20a et 20b. Ces tensions peuvent être continues ou pulsées. Elles dépendent de la haute tension appliquée à l'anode 8, de la tension appliquée aux grilles 40 de la source et de la distance entre l'anode et la source. Elles sont optimisées pour une bonne focalisation en ruban.

La puissance totale "P" reçue par l'anode et, dans le cas particulier du laser, par la cavité, dépend beaucoup de la focalisation du faisceau, et en particulier, de la largeur l du ruban d'excitation. Pour une cible donnée, de longueur L (figure 1), et pour une densité électronique utile D, la puissance sera donnée par P=D.L.l.

Pour une tension d'accélération V donnée, appliquée à l'anode, le courant électronique I est défini par I=D.L.l/V

### EXEMPLE NUMERIQUE

Avec V=10kV, L=600µm et D=2kW/cm², on a :
- pour l=150µm, P=1,8W et I=180µA, et
- pour l=10µm, P=120mW et I=12µA.

Ces valeurs numériques montrent qu'une bonne focalisation, correspondant à la largeur l de ruban minimum, permet :
- de diminuer la puissance totale fournie par le canon, et donc de simplifier son refroidissement,
- de tolérer des densités de courant d'excitation (fixées par les tensions cathodiques, de grilles et d'anode) plus élevées, car on peut augmenter, à puissance égale, la densité électronique de courant par une bonne focalisation,
- de diminuer notablement le courant de fonctionnement, et donc de moins solliciter les micropointes.

La chaleur dégagée par le bombardement électronique peut alors être évacuée tout simplement par une masse thermique (système 32) supportant l'anode, comportant éventuellement un refroidisseur du type élément Peltier.

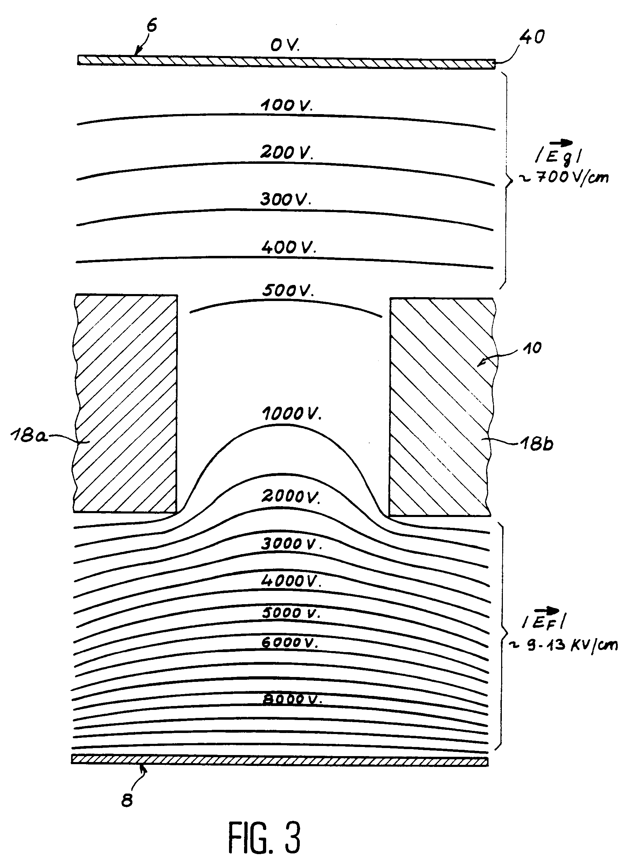

La figure 3 permet d'illustrer la séparation en deux zones de champ électrique dans le canon à électrons, grâce à l'ensemble d'électrodes 10.

Les lignes équipotentielles représentées sur cette figure résultent d'un calcul numérique. Elles ont été déterminées pour des grilles 40 portées à une tension de 0 volts, une anode 8 portée à une tension de 10kV et des électrodes 18a et 18b de l'ensemble 10 portées respectivement à des tensions de +500V. Les électrodes 20a et 20b sont portées à une tension de -100V. La distance séparant les grilles de l'anode est de 20mm ; les électrodes ont une hauteur de 6mm et la distance séparant l'anode des électrodes est de 7mm.

Cette répartition des lignes équipotentielles permet bien l'obtention d'un champ électrostatique faible E_{f} entre la source 6 et l'ensemble 10 d'électrodes de 700V/cm environ et l'obtention d'un champ électrostatique fort E_{F} de 9 à 13kV/cm entre l'ensemble d'électrodes 10 et l'anode 8.

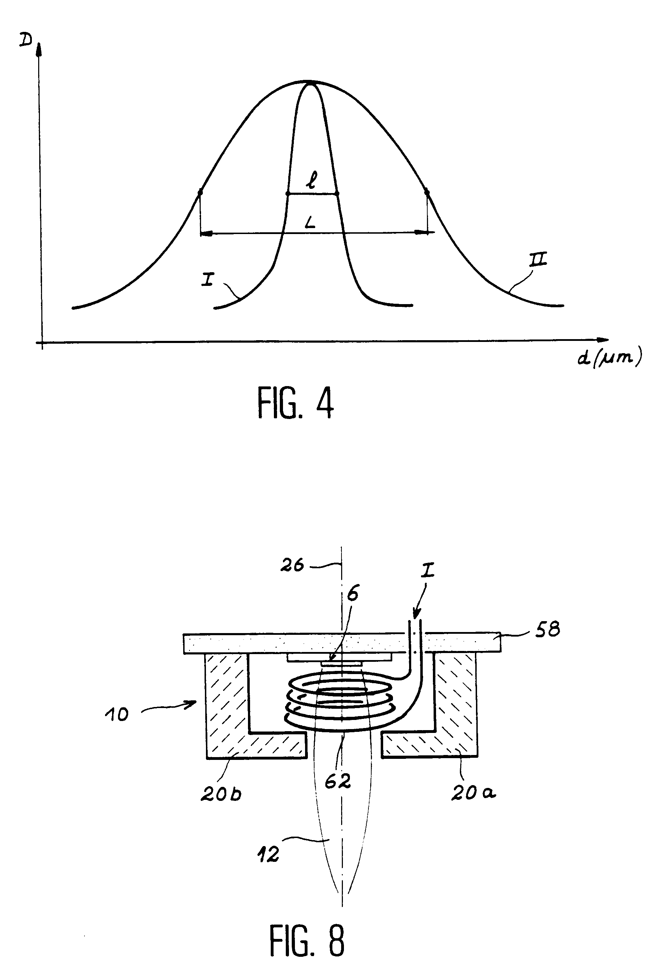

Sur la figure 4, on a représenté les variations de la densité électronique D, exprimée en unité arbitraire, en fonction des dimensions d, exprimées en µm, du ruban 14 d'électrons. La courbe I donne les variations de la densité électronique selon une direction parallèle à la largeur l du ruban et la courbe II donne ces mêmes variations selon une direction parallèle à la longueur L du ruban. La largeur à mi-hauteur des profils I et II correspond respectivement à la largeur et la longueur du ruban.

Pour un réseau de micropointes rectangulaires de 0,5x1mm², des distances source-électrodes et électrodes-anode de 6mm, des tensions sur les électrodes 18a et 18b de +600V et sur les électrodes 20a et 20b de -100V, une tension d'anode de 10kV, des écartements des électrodes 18a et 18b de 4mm et des électrodes 20a et 20b de 7mm, une hauteur de 6mm pour les électrodes 18a et 18b et de 2,5mm pour les électrodes 20a et 20b et une anode plane, on obtient un ruban de focalisation d'environ 100 à 150µm de large sur 600µm de long.

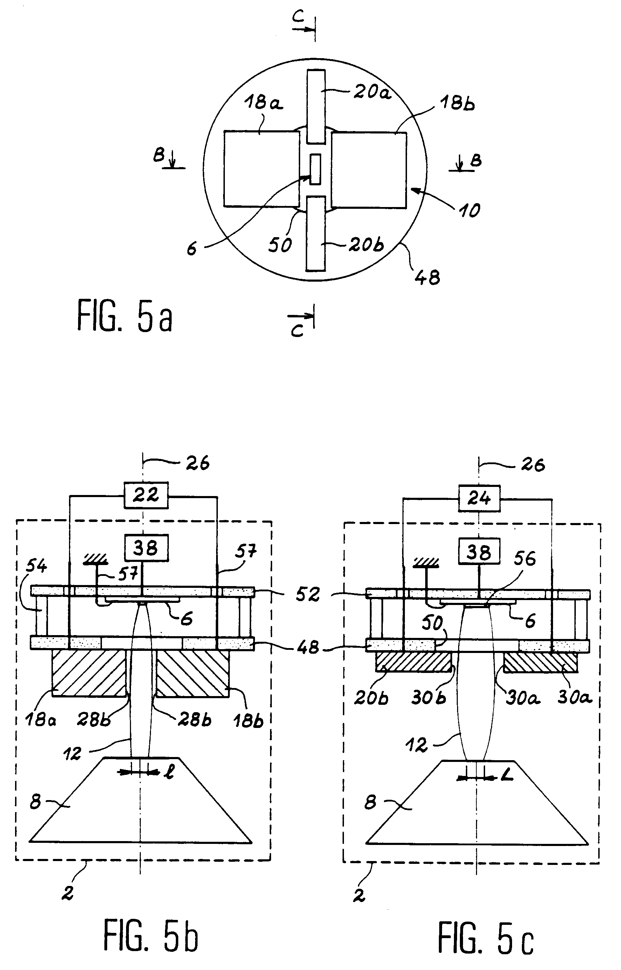

Différents modes de réalisation pratique du canon à électrons de l'invention peuvent être envisagés comme représenté sur les figures 5a à 8. Sur ces figures, l'ensemble 10 d'électrodes ne comporte que deux paires d'électrodes. Bien entendu, ceci n'est qu'un exemple particulier de réalisation et il est notamment possible d'utiliser trois, quatre ou plus de paires d'électrodes de dimensions distinctes.

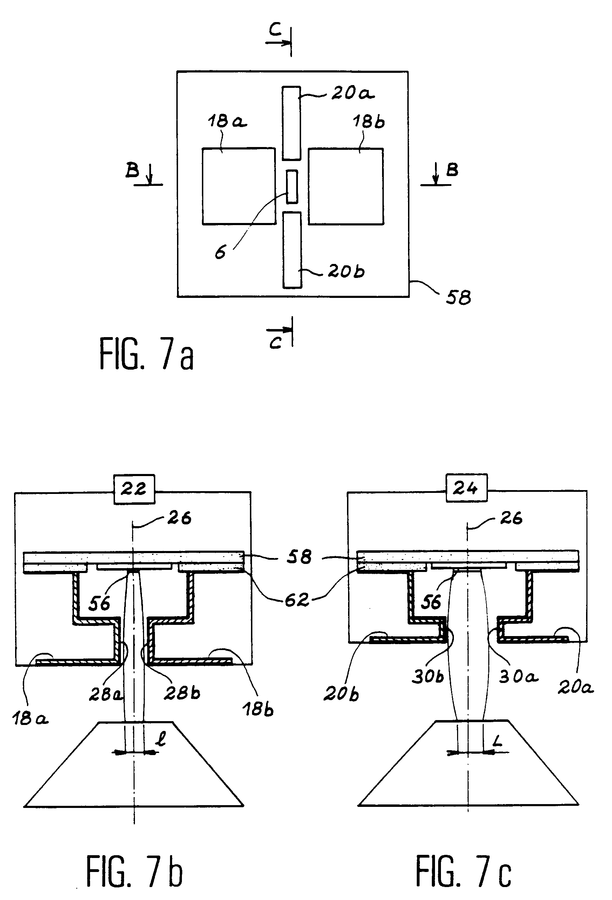

Dans le mode de réalisation des figures 5a à 5c, la source et les électrodes sont montées sur des supports isolants séparés alors que les modes de réalisation représentés sur les figures 6a-6c et 7a-7c correspondent à un montage hybride.

Sur les figures 5a à 5c, les électrodes 18a, 18b, 20a et 20b sont montées sur un disque 48 isolant électrique réalisé par exemple en verre ou en céramique (SiO₂, Al₂O₃,) percé en son centre d'un trou 50 destiné au passage du faisceau d'électrons 12. Ce trou 50 est tel que les faces parallèles en regard des électrodes 28a, 28b et 30a, 30b font saillie dans le trou 50.

Dans ce mode de réalisation, on trouve un autre disque 52 isolant, par exemple en verre ou en céramique, disposé parallèlement au disque 48 et en amont de ce dernier, sur lequel est fixée notamment par collage la source d'électrons 6. Les cathodes 36 (figure 2) sont fabriquées soit directement sur cette plaque 52, soit collées avec leur support 34 au centre de la plaque 52.

Des cales d'épaisseur 54 disposées à la périphérie des disques 48 et 52 permettent d'assurer une distance constante entre ces deux disques. Ces cales 54 sont rendues solidaires des disques 48 et 52 par collage. De même, les électrodes 18a-18b sont solidaires du disque 48 par collage.

La référence 56 indique la matrice de micropointes de la source 6.

La source 6 et le trou 50 du disque 48 sont bien sûr alignés avec l'anode 8 selon l'axe 26.

Les électrodes 18a, 18b, 20a et 20b sont, dans le mode représenté sur les figures 5a à 5c, des pièces entièrement métalliques, réalisées en cuivre, molybdène, ... par exemple.

Dans ce cas, les disques 48 et 52 sont équipés de vias traversés par des conducteurs 57 métalliques assurant la connexion des électrodes et de la source respectivement aux sources de tension 22, 24 et 38.

Dans les variantes des figures 6a à 7c, l'ensemble source-électrodes est monté sur une même plaque isolante (verre ou céramique) 58 comportant des métallisations (non représentées) pour la polarisation électrique des différents éléments du canon à électrons.

Par ailleurs, dans la variante des figures 6a à 6c, les électrodes sont constituées de pièces isolantes en céramique (SiO₂, Si₃N₄, ...) recouvertes d'une couche de métal 60 par exemple de cuivre, d'or, d'argent, déposée par évaporation sous vide. Cette couche 60 ne peut être formée que sur les parties des électrodes en regard du faisceau d'électrons 12 et du support isolant 58. Bien entendu, ces électrodes pourraient être entièrement métalliques comme sur les figures 5a à 5c.

Dans la variante des figures 7a à 7c, les électrodes sont constituées par des plaques métalliques pliées, sans support isolant.

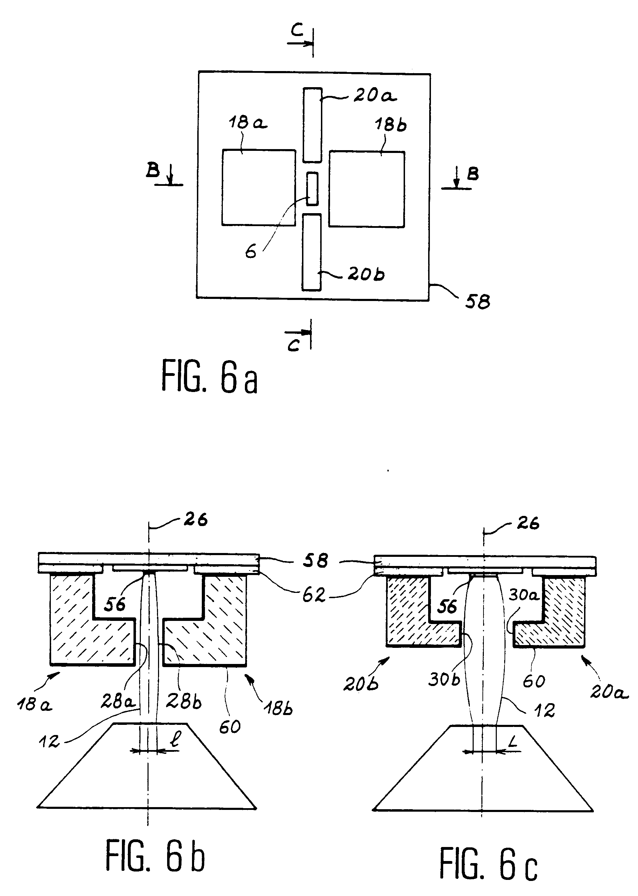

Contrairement aux figures 1, 5b et 5c, les électrodes des figures 6a à 7c ne présentent plus la forme d'un parallélépipède rectangle. Elles présentent en coupe, selon un plan de symétrie passant par l'axe 26 (plans des figures 6b, 6c, 7b et 7c), la forme d'un L, les extrémités libres de chaque électrode en L faisant face au faisceau d'électrons. Ces extrémités présentent donc des faces planes parallèles entre elles deux à deux référencées respectivement 28a, 28b, 30a, 30b.

Les électrodes en L sont collées sur la plaque isolante 58 autour de la source 6 à micropointes, sur des pistes métallisées (non représentées), qui permettent leur polarisation électrique.

Ses électrodes peuvent être formées directement sur la plaque isolante 58 (comme représenté sur la figure 8) ou bien être supportées par un support 62 entourant le substrat 34 de la source 6, comme représenté sur les figures 6b et 6c, 7a et 7b.

Les opérations de collage des différents supports isolants peuvent être réalisées par une machine automatique du type de celle utilisée en microélectronique pour le montage de circuits hybrides. Cette machine automatique assurera en outre le positionnement précis des différents éléments du canon à électrons et en particulier le centrage de la source par rapport aux électrodes 18a, 18b, 20a et 20b selon l'axe 26.

Afin d'assurer une mise en forme préliminaire du faisceau d'électrons, il est possible, d'associer à l'ensemble des électrodes 10 une lentille électromagnétique, constituée par exemple, comme représenté sur la figure 8, par une bobine 62 d'un fil conducteur parcouru par un courant I, cette bobine entourant le faisceau d'électrons 12. En effet, l'axe longitudinal de symétrie de la bobine est centré sur l'axe 26 du canon à électrons.

La figure 8 est une vue en coupe du canon à électrons dans le même plan que celui des figures 6c et 7c.

Bien que le canon à électrons de l'invention puisse être utilisé dans un domaine autre que celui des lasers, ce canon est parfaitement bien adapté au pompage électronique d'un laser à semi-conducteur. Un tel laser est représenté schématiquement sur les figures 9a et 9b. Ce laser est un laser à hétérostructure mais bien entendu, il est possible d'utiliser le canon de l'invention avec d'autres types de lasers à semi-conducteurs.

Ce laser comporte le canon à électrons 1 décrit précédemment associé à une cavité laser de référence générale 70. Cette cavité (figure 9b) a la forme d'un barreau comportant deux faces parallèles 71 et 73 obtenues par clivage et constituant les miroirs semi-réfléchissants de la cavité laser. Ces faces 71 et 73 sont perpendiculaires à la surface des différentes couches constituant la cavité 70.

Cette cavité 70 comporte un substrat 72 sur lequel on a épitaxié une couche tampon 74, une couche inférieure 76 de confinement latéral de la lumière, une couche active 78, une couche supérieure 80 de confinement latéral de la lumière et une couche 82 d'excitation électronique. Cette couche 82 est destinée à être bombardée par le faisceau d'électrons 12 focalisé sous forme du ruban 14.

Le canon à électrons 1 et la cavité laser 70 sont alignés de façon à focaliser les électrons selon un ruban 14 dont la longueur est orientée perpendiculairement aux miroirs ou faces clivées 71 et 73 de la cavité laser. L'ensemble canon à électrons-cavité laser est logé dans l'enceinte à ultravide 2 comportant des fenêtres 84 transparentes à la lumière émise par la structure laser.

Le laser représenté sur les figures 9a et 9b est en particulier un laser à hétérostructure constitué de couches semi-conductrices en matériau II-VI. Le semi-conducteur utilisé est en particulier du Cd_{z}Mn_{1-z}Te avec z variant de 0 à 1.

Par exemple, le substrat a une composition z en Cd de 1 et la couche tampon a une composition z en cadmium de 0,75, les couches de confinement 76 et 80 une composition z en cadmium variant graduellement de 0,75 à 0,85 en partant du substrat, la composition z de la couche active 78 est égale à 1 et la composition z en cadmium de la couche d'excitation varie graduellement de 0,75 à 0,70 en partant du substrat.

Bien entendu, d'autres structures semi-conductrices II-VI peuvent être envisagées. En outre, le laser de l'invention peut comporter une structure semi-conductrice en matériau III-V, par exemple en GaₓAl₁₋ₓAs avec x variant de 0 à 1.

## Revendications

1. Canon à électrons compact comportant une source froide (2) d'électrons pourvue de conducteurs cathodiques (36) supportant des micropointes (39) émettrices d'électrons ; une anode (8) haute tension distante des micropointes, faisant face aux micropointes ; des moyens (16) pour appliquer une haute tension sur l'anode ; un ensemble d'électrodes (10) pour focaliser sur l'anode sous forme d'un ruban (14) le faisceau d'électrons (12) émis par la source et pour servir d'écran électrostatique à la source contre la haute tension appliquée à l'anode, cet ensemble étant interposé entre la source et l'anode et comportant au moins deux paires d'électrodes (18a, 18b, 20a, 20b) de dimensions distinctes et portées respectivement à des tensions positives et négatives dont leur valeur est telle qu'un champ électrostatique faible (E_{f}) est créé entre la source et l'ensemble d'électrodes et qu'un champ électrostatique fort (E_{F}) est créé entre l'ensemble d'électrodes et l'anode, ces électrodes étant réparties autour du faisceau d'électrons, des moyens (22, 24) pour appliquer une tension moyenne sur l'ensemble d'électrodes, et des moyens (38) pour appliquer une tension appropriée sur les conducteurs cathodiques.

2. Canon à électrons selon la revendication 1, caractérisé en ce que l'ensemble d'électrodes (10) comporte des moyens (19a, 19b) pour effectuer un balayage du faisceau d'électrons selon une direction perpendiculaire au faisceau d'électrons.

3. Canon à électrons selon la revendication 1 ou 2, caractérisé en ce que l'ensemble d'électrodes comporte, de plus, des circuits électromagnétiques (62) parcourus par un courant, entourant le faisceau d'électrons.

4. Canon à électrons selon l'une quelconque des revendications 1 à 3, caractérisé en ce que la source d'électrons comporte des électrodes de grilles (40) portées au potentiel de la masse, isolées des conducteurs cathodiques et comportant des trous (44) en regard des micropointes.

5. Canon à électrons selon l'une quelconque des revendications 1 à 4, caractérisé en ce que les électrodes présentent une face (28a, 28b, 30a, 30b) plane en regard du faisceau d'électrons, les faces planes (28a, 28b) des électrodes d'une paire étant perpendiculaires aux faces planes (30a, 30b) des électrodes de l'autre paire.

6. Canon à électrons selon l'une quelconque des revendications 1 à 5, caractérisé en ce que des supports isolants (48, 52) sont prévus pour supporter la source et l'ensemble (10) d'électrodes, les supports isolants de la source et dudit ensemble étant distincts.

7. Canon à électrons selon l'une quelconque des revendications 1 à 6, caractérisé en ce que les micropointes (39) sont agencées selon un réseau rectangulaire en vue de dessus.

8. Canon à électrons selon l'une quelconque des revendications 1 à 7, caractérisé en ce que l'anode (8) a la forme d'un cône ou d'une pyramide.

9. Laser à semi-conducteur pompé électroniquement, comportant une cavité laser à semi-conducteur (70) et des moyens de pompage électronique de la cavité, caractérisé en ce que les moyens de pompage consistent en un canon à électrons (1) selon l'une quelconque des revendications 1 à 8.

10. Laser selon la revendication 9, caractérisé en ce que l'ensemble d'électrodes est agencé pour focaliser sur l'anode le faisceau d'électrons en forme de ruban (14) dont la largeur (l) est minimum et la longueur (L) est égale à la largeur de la cavité laser.

11. Laser selon l'une quelconque des revendications 9 et 10, caractérisé en ce que la cavité laser (70) consiste en une hétérostructure semi-conductrice.

12. Laser selon l'une quelconque des revendications 9 à 11, caractérisé en ce que la cavité laser (70) est réalisée en des matériaux II-VI.

## Patentansprüche

1. Kompakte Elektronenkanone, umfassend eine kalte Elektronenquelle (2), versehen mit Kathodenleitern (36), die elektronenemittierende Mikrospitzen (39) tragen; eine Hochspannungsanode (8), von den Mikrospitzen beabstandet, den Mikrospitzen gegenüberstehend; Einrichtungen (16), um eine Hochspannung an die Anode zu legen; eine Elektrodeneinheit (10), um den durch die Quelle emittierten Elektronenstrahl (12) in Form eines Streifens (14) auf die Anode zu fokussieren und um der Quelle als elektrostatischer Schirm zu dienen gegen die an die Anode gelegte Hochspannung, wobei diese Einheit eingefügt ist zwischen die Quelle und die Anode und wenigstens zwei Paar Elektroden (18a, 18b, 20a, 20b) mit unterschiedlichen Abmessungen umfaßt, jeweils auf positive und negative Spannungen gebracht, deren Wert derart ist, daß ein schwaches elektrostatisches Feld (E_{f}) erzeugt wird zwischen der Quelle und der Elektrodeneinheit, und daß ein starkes elektrostatisches Feld (E_{F}) erzeugt wird zwischen der Elektrodeneinheit und der Anode, wobei diese Elektroden um den Elektronenstrahl herum verteilt sind, Einrichtungen (22, 24), um eine Mittelspannung an die Elektrodeneinheit zu legen, und Einrichtungen (38), um eine geeignete Spannung an die Kathodenleiter zu legen.

2. Elektronenkanone nach Anspruch 1, dadurch gekennzeichnet, daß die Elektrodeneinheit (10) Einrichtungen (19a, 19b) zum Abtasten des Elektronenstrahls in einer zum Elektronenstrahl senkrechten Richtung umfaßt.

3. Elektronenkanone nach Anspruch 1 oder 2, dadurch gekennzeichnet, daß die Elektrodeneinheit außerdem stromdurchflossene elektromagnetische Kreise (62) umfaßt, die den Elektronenstrahl umgeben.

4. Elektronenkanone nach einem der Ansprüche 1 bis 3, dadurch gekennzeichnet, daß die Elektronenquelle Gitterelektroden (40) umfaßt, die an Masse liegen, von den Kathodenleitern isoliert sind und gegenüber den Mikrospitzen Löcher (44) aufweisen.

5. Elektronenkanone nach einem der Ansprüche 1 bis 4, dadurch gekennzeichnet, daß die Elektroden gegenüber dem Elektronenstrahl eine Planfläche (28a, 28b, 30a, 30b) aufweisen, wobei die Planflächen (28a, 28b) der Elektroden eines Paares senkrecht sind zu den Planflächen (30a, 30b) der Elektroden des anderen Paares.

6. Elektronenkanone nach einem der Ansprüche 1 bis 5, dadurch gekennzeichnet, daß isolierende Träger (48, 52) vorgesehen sind, um die Quelle und die Elektrodeneinheit (10) zu tragen, wobei die isolierenden Träger der Quelle und der besagten Einheit unterschiedlich sind.

7. Elektronenkanone nach einem der Ansprüche 1 bis 6, dadurch gekennzeichnet, daß die Mikrospitzen (39) von oben gesehen einem rechtwinkligen Raster entsprechend angeordnet sind.

8. Elektronenkanone nach einem der Ansprüche 1 bis 7, dadurch gekennzeichnet, daß die Anode die Form eines Konus oder einer Pyramide aufweist.

9. Elektronisch gepumpter Halbleiterlaser, umfassend einen Halbleiter-Laserresonator (70) und elektronische Pumpeinrichtungen des Resonator,
**dadurch gekennzeichnet,** daß die Pumpeinrichtungen gebildet werden durch eine Elektronenkanone (1) nach einem der Ansprüche 1 bis 8.

10. Laser nach Anspruch 9, dadurch gekennzeichnet, daß die Elektrodeneinheit angeordnet ist, um den Elektronenstrahl auf die Anode zu fokussieren in Form eines Streifens (14), dessen Breite (1) minimal ist und dessen Länge (L) gleich der Breite des Laserresonators ist.

11. Laser nach einem der Ansprüche 9 und 10, dadurch gekennzeichnet, daß der Laserresonator (70) gebildet wird durch eine Halbleiter-Heterostruktur.

12. Laser nach einem der Ansprüche 9 bis 11, dadurch gekennzeichnet, daß der Laserresonator (70) aus II-VI-Materialien hergestellt ist.

## Claims

1. Compact electron gun having a cold electron source (2) provided with cathode conductors (36) supporting electron emitting microdots (39), a high voltage anode (8) spaced from the microdots and facing the latter, means (16) for applying a high voltage to the anode, an array of electrodes (10) for focussing onto the anode and in the form of a strip (14) the electron beam (12) emitted by the source and serving to electrostatically screen the source from the high voltage applied to the anode, said array being placed between the source and the anode and having at least two pairs of electrodes (18a, 18b, 20a, 20b) of different dimensions and respectively raised to positive and negative voltages, whereof their value is such that a weak electrostatic field (E_{f}) is formed between the source and the electrode array and that a strong electrostatic field (E_{f}) is formed between the electrode array and the electron beam, means (22, 24) for applying a medium voltage to the electrode array, and means (38) for applying an appropriate voltage to the cathode conductors.

2. Electron gun according to claim 1, characterized in that the electrode array (10) has means (19a, 19b) for scanning the electron beam in a direction perpendicular thereto.

3. Electron gun according to claim 1 or 2, characterized in that the electrode array also has electromagnetic circuits (62) traversed by a current surrounding the electron beam.

4. Electron gun according to any one of the claims 1 to 3, characterized in that the electron source has grid electrodes (40) raised to earth potential and insulated from the cathode conductors and having holes (44) facing the microdots.

5. Electron gun according to any one of the claims 1 to 4, characterized in that the electrodes have a planar face (28a, 28b, 30a, 30b) facing the electron beam, the planar faces (28a, 28b) of the electrodes of one pair being perpendicular to the planar faces (30a, 30b) of the electrodes of the other pair.

6. Electron gun according to any one of the claims 1 to 5, characterized in that insulating supports (48, 52) are provided for supporting the source and the electrode array (10), the insulating supports of the source and of the array being separate.

7. Electron gun according to any one of the claims 1 to 6, characterized in that the microdots (39) are arranged in accordance with a rectangular network in plan view.

8. Electron gun according to any one of the claims 1 to 7, characterized in that the anode (8) is shaped like a cone or pyramid.

9. Electronically pumped semiconductor laser having a semiconductor laser cavity (70) and electronic pumping means for the cavity, characterized in that the pumping means are constituted by an electron gun (1) according to claim 1.

10. Laser according to claim 9, characterized in that the electrode array is arranged so as to focus onto the anode the strip-like electron beam (14), whose width (l) is minimum and whose length (L) is equal to the width of the laser cavity.

11. Laser according to claim 9 or 10, characterized in that the laser cavity (70) consists of a semiconductor heterostructure.

12. Laser according to any one of the claims 9 to 11, characterized in that the laser cavity (70) is made from II-VI materials.
